# FASCICULE DE BREVET EUROPEEN

(11) **EP 3 761 504 B1**
(45) Date de publication et mention de la délivrance du brevet: **01.12.2021**
(21) Numéro de dépôt: 20184052.7
(22) Date de dépôt: 03.07.2020
(51) Int. Cl.: H03H 7/25, H01Q 3/28, H01Q 3/36, H04B 7/06, H04B 7/08

(54) **CONSTELLATION VECTORIELLE MULTI-ECHELLE**
MEHRSTUFIGE VEKTORIELLE KONSTELLATION
MULTI-SCALE VECTOR CONSTELLATION

(30) Priorité: 04.07.2019 FR 1907443
(43) Date de publication de la demande: 06.01.2021
(73) Titulaire: THALES, 92400 Courbevoie (FR); CENTRE NATIONAL D'ETUDES SPATIALES, 75039 Paris Cedex 01 (FR)
(72) Inventeur: ROCHETTE, Stéphane, 31037 TOULOUSE CEDEX 1 (FR); ADAM, Thierry, 31037 TOULOUSE CEDEX 1 (FR); THEROND, Benjamin, 31037 TOULOUSE CEDEX 1 (FR); ARMENGAUD, Vincent, 31401 TOULOUSE CEDEX 9 (FR)
(74) Mandataire: Marks & Clerk France

(56) Documents cités:
- EP-A1- 3 324 540
- FR-A1- 2 338 582
- US-A- 5 661 489

## Description

### Domaine technique :

L'invention se situe dans le domaine des transmissions radiofréquences (RF), et porte plus particulièrement sur un dispositif de commande de l'amplitude et de la phase d'un signal RF, ou nœud de contrôle, utilisé au sein d'un réseau de formateurs de faisceaux (en anglais « beamforming network ») pour antennes réseau, en particulier pour les communications satellitaires.

### Technique antérieure :

Les antennes réseau, qu'elles soient actives ou passives, sont des antennes composées d'une pluralité d'éléments rayonnants utilisés pour transmettre ou recevoir un signal RF. L'amplitude et la phase du signal transmis (lorsque l'antenne est utilisée en émission) ou reçu (lorsque l'antenne est utilisée en réception) par chaque élément rayonnant sont ajustées de manière à diriger le faisceau de l'antenne dans la direction souhaitée.

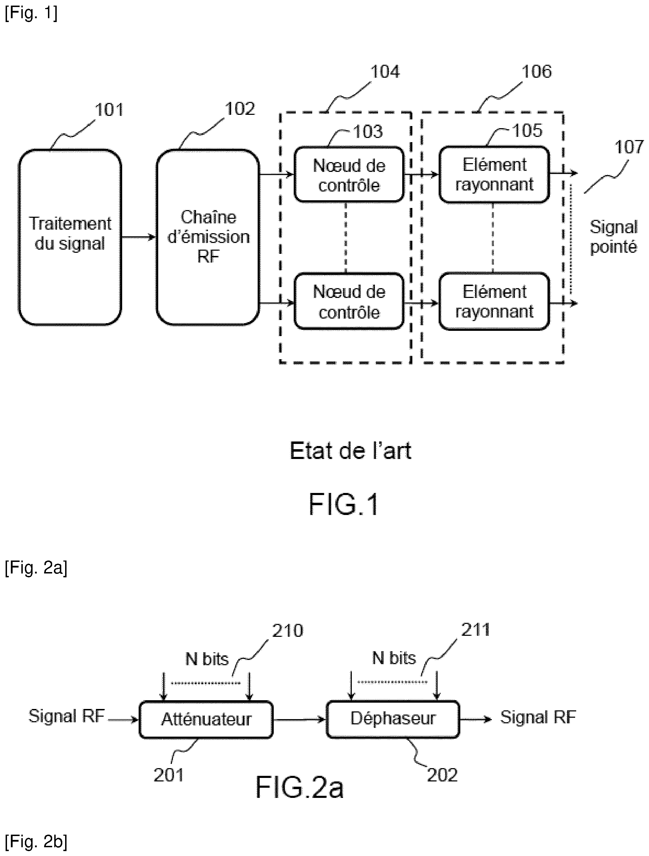

La figure 1 représente sommairement les principaux éléments d'une chaîne d'émission comprenant une antenne réseau. Le signal à transmettre est mis en forme par différents algorithmes 101 de traitement du signal (modulation, codage, entrelacement, etc...) en fonction du standard de communications, puis converti en analogique et amplifié par la chaîne d'émission 102. Le signal RF généré est transmis à N nœuds de contrôle unitaires 103, formant ensemble un réseau de formateurs de faisceaux 104. Chaque nœud de contrôle est configuré pour appliquer au signal un déphasage et une atténuation particulière en fonction d'un signal de commande. Le signal RF ainsi modifié est transmis à un élément rayonnant particulier 105 de l'antenne réseau 106 pour être émis. Le choix des amplitudes/phases appliqués par les nœuds de contrôle permet de piloter la direction du signal RF émis par l'antenne. Les chaînes de réceptions sont similaires, une amplitude et une phase particulière étant appliquée par les nœuds de contrôle à chaque signal RF reçu depuis les éléments rayonnants de l'antenne réseau.

Les techniques de formation de faisceaux sont bien connues de l'état de l'art, et utilisées en particulier à bord des satellites pour créer des spots satellitaires.

La précision du pointage dépend du nombre d'éléments rayonnants qui composent l'antenne. Ainsi, les antennes embarquées à bord des satellites comprennent généralement plusieurs dizaines d'éléments rayonnants. De par leur nombre, les nœuds de contrôle sont des éléments dimensionnants en termes de masse, de volume et de consommation à bord du satellite. Pour cette raison, les technologies généralement retenues pour implémenter les nœuds de contrôle sont les technologies silicium ou à base de mélanges silicium/germanium, qui offrent de bonnes performances RF tout en étant avantageuses en terme d'intégration des fonctions et d'efficacité énergétique.

Chaque nœud de contrôle est piloté par un signal de commande numérique. Pour un nombre de bits donnés du signal de commande, il existe donc un nombre fini d'états d'amplitude/phase pouvant être obtenus. L'ensemble de ces états forme une constellation de points. Par exemple, pour une configuration de commande de 16 bits, la constellation comprend 65536 états différents d'amplitude/phase. La plupart des systèmes satellitaires actuels utilisent un signal de commande sur 16 bits, car ce format est compatible avec les dispositifs standards d'adressage série-parallèle, de stockage mémoire des mots de commande et de calibrage de l'antenne réseau. Cependant, certains contextes applicatifs (orbite satellite basse, bande fréquentielle relative élevée, ...) exigent la réduction de la taille de cette constellation à 2¹⁴ = 16384 états, de manière à réserver 2 bits parmi les 16 disponibles pour le réglage du paramètre « temps de propagation de groupe ».

Les nœuds de contrôle unitaires doivent également répondre à des spécifications de résolution concernant les points de la constellation d'états. Par exemple, la consigne de phase doit généralement permettre de balayer 360° par pas de taille constante, et la dynamique d'amplitude doit être importante (typiquement supérieure à 20dB).

Il est connu de l'état de l'art antérieur des nœuds de contrôle basés sur des topologies dites « polaires », à pas de commande fixe en amplitude et en phase.

La figure 2a représente le synoptique d'un nœud de contrôle unitaire à topologie polaire piloté par un signal de commande sur 2N bits. Le nœud de contrôle comprend alors un atténuateur 201, composé de cellules d'atténuation successives, configuré pour atténuer le signal RF d'entrée en fonction de la valeur de N bits 210 du signal de commande, et d'un déphaseur 202 configuré pour appliquer au signal RF atténué un déphasage en fonction de la valeur de N autres bits 211 du signal de commande. Un résultat identique peut être obtenu en inversant la position de l'atténuateur 201 et du déphaseur 202.

Dans les exemples décrits par la suite, on considèrera à titre d'illustration le cas d'un signal de commande de taille 2N = 14 bits. L'invention n'est aucunement limitée à ce nombre de bits puisque c'est une pratique courante à l'homme du métier que de faire varier le nombre de bits du signal de commande. Dans ce cas précis, N = 7 bits sont dédiés au contrôle de l'atténuateur 201. Celui-ci comprend alors 7 cellules d'atténuation consécutives pilotées par des bits respectifs du signal de commande, qui permet de commuter chaque cellule entre l'état actif et inactif. Les cellules d'atténuation successives ont une atténuation qui double pour chaque cellule de manière à garantir une progression logarithmique à pas constant. Dans cet exemple, il est alors possible d'appliquer 128 niveaux d'atténuation au signal RF. La dynamique d'amplitude souhaitée est alors dépendante du pas d'atténuation. En considérant MSB (sigle anglais pour « Most Significant Bit ») comme étant le bit de poids fort et LSB (sigle anglais pour « Least Significant Bit ») comme étant le bit de poids faible des N bits dédiés du signal de commande, alors le pas d'atténuation de l'atténuateur correspond à l'atténuation de la cellule associée au LSB, l'atténuation de la cellule associée au MSB vaut 2^{N-1} fois l'atténuation de la cellule associée au LSB, et la dynamique d'amplitude vaut 2 * MSB - LSB = (2^{N} - 1) * LSB.

En outre, N = 7 autres bits 211 du signal de commande sont utilisés pour contrôler le déphaseur 202, ce qui permet d'appliquer 128 déphasages distincts au signal, de préférence répartis uniformément pour couvrir les 360° de phase requis par le système antenne réseau. Le pas de phase vaut alors 360° / 2^{N}.

En fonction des souhaits concernant la précision de phase et la dynamique d'amplitude recherchées, la répartition des bits de commande entre l'atténuateur et le déphaseur peut être modifiée.

La figure 2b représente la constellation d'états obtenue pour des nœuds de contrôle utilisant une topologie polaire, dans le cas d'une constellation idéale, c'est-à-dire sans loi parasite, pour N = 7. La constellation couvre de manière homogène le cercle unité, qui correspond à une atténuation nulle. Les atténuations sont données en décibels et représentées sur une échelle logarithmique, ce qui explique que la distance entre deux états successifs associés à une même phase diminue lorsque l'atténuation augmente.

Si la représentation polaire est très intéressante d'un point de vue du fonctionnement du système de par sa couverture homogène, son implémentation en technologie silicium ou en silicium-germanium est très pénalisante en termes de surface et de compromis sur l'ensemble des performances électriques requises (caractéristiques RF critiques versus puissance de courant continu consommée).

C'est pourquoi il est également connu de l'état de l'art antérieur des nœuds de contrôle unitaires basés sur des topologies dites « vectorielles », à pas de commande fixe en amplitude sur les voies I et Q.

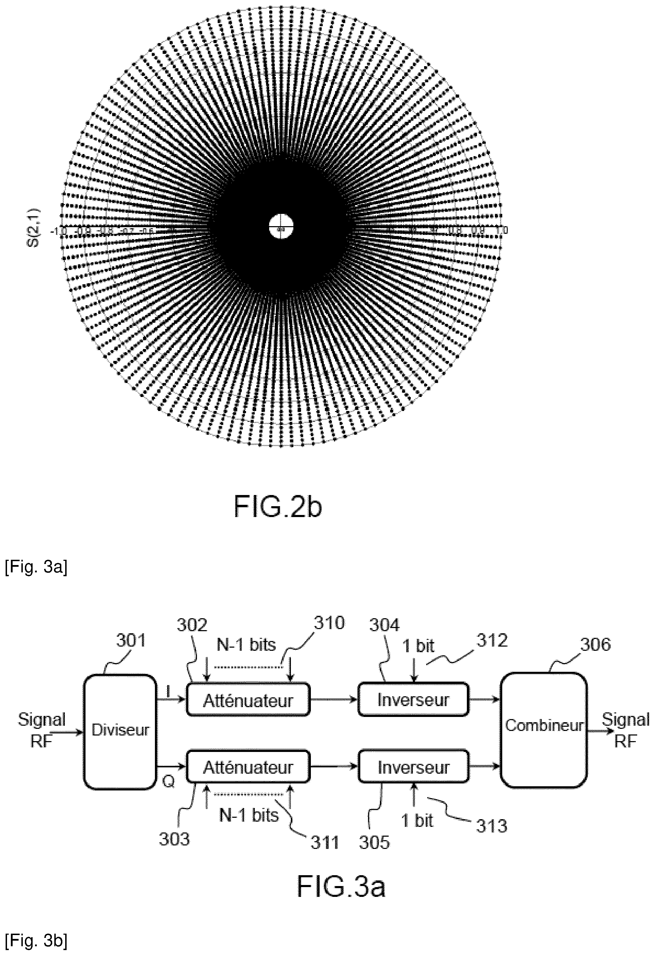

La figure 3a représente un synoptique d'un nœud de contrôle unitaire à topologie vectorielle piloté par un signal de commande à 2N bits. Le nœud de contrôle comprend un diviseur quadratique 301 configuré pour générer, à partir du signal RF, un signal en phase, communément dénommé voie I, et un signal en quadrature de phase, communément dénommé voie Q. Chaque voie comprend un atténuateur 302/303 configuré pour atténuer le signal de la voie en fonction de la valeur de N - 1 bits 310/311 du signal de commande, et un inverseur 304/305, configuré pour inverser ou non le signal transmis sur la voie en fonction de la valeur d'un bit 312/313 du signal de commande. Les deux signaux sont ensuite recombinés par un combineur 306. Le diviseur quadratique peut par exemple prendre la forme d'un coupleur utilisé en mode diviseur, configuré pour générer deux voies de sorties en quadrature. Le combineur peut par exemple prendre la forme d'un coupleur utilisé en combineur dont les voies d'entrées sont en phase ou en opposition de phase.

Dans des variantes d'implémentation, la position des atténuateurs et des inverseurs sur chaque voie peut être permutée. De même, le diviseur quadratique 301 peut être configuré pour générer 4 voies : les voies *I* et Q, ainsi que leurs inverses *I̅* et *Q̅*. Chaque voie comprend alors un atténuateur, mais les atténuateurs d'une voie et de son inverse sont commandés par les mêmes bits du signal de commande (N-1 bits 310 du signal de commande pour les voies *I* et *I̅*, et N - 1 bits 311 du signal de commande pour les voies Q et *Q̅*). La présence d'inverseurs n'est alors plus requise, mais le combineur doit être configuré pour combiner deux voies parmi les quatre, sélectionnées à partir de deux bits du signal de commande.

La topologie vectorielle est très avantageuse par rapport à la topologie polaire en termes de surface d'implémentation, de performances en pertes d'insertion RF et en largeur de bande fréquentielle relative, en particulier lorsque l'implémentation se fait en technologie silicium ou silicium-germanium.

La figure 3b représente la constellation d'états obtenue pour des nœuds de contrôle utilisant une topologie vectorielle, dans le cas d'une constellation idéale, c'est-à-dire sans Ioi parasite, et pour un signal de commande sur 2N = 14 bits. Les atténuateurs 302/303 comprennent chacun N - 1 = 6 cellules d'atténuation consécutives, chaque cellule étant contrôlée par un bit particulier du signal de commande. L'atténuation réalisée par les cellules double d'une cellule à l'autre, de manière à réaliser une atténuation à pas constant en dB. Dans cet exemple, il est alors possible d'appliquer 64 niveaux d'atténuation au signal RF sur chaque voie, ce qui permet de décrire 4096 niveaux d'amplitude/phase regroupés dans un quadrant de la constellation totale. Les inverseurs permettent de reporter ces états sur les trois autres quadrants. La dynamique de l'atténuation apportée sur chaque voie étant limitée, des zones de dépeuplement 320 apparaissent le long des axes x et y, dans lesquelles la constellation ne comprend pas de points.

De ce fait, la topologie vectorielle n'apporte pas une réponse appropriée à la problématique de couverture homogène sur 360° et sur l'ensemble de la dynamique recherchée.

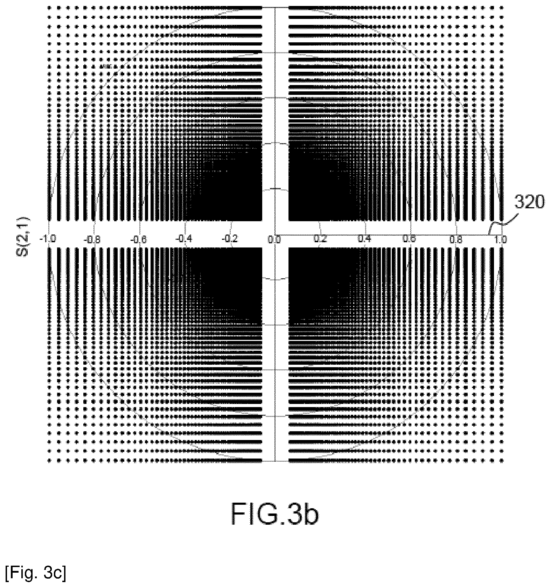

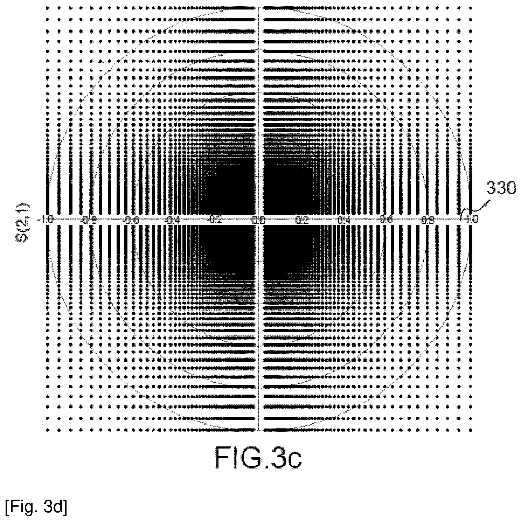

Jusqu'ici, le problème était résolu en utilisant une ou plusieurs des techniques suivantes :
- tolérer la présence d'angles totalement dépeuplés, comme par exemple l'angle 0° dans le cas de la figure 2b. En effet, les standards de télécommunications prévoient des marges sur les erreurs de phase, mais cette solution n'est pas satisfaisante ;
- augmenter la taille du signal de commande et le nombre de cellules d'atténuation pour augmenter à pas constant la dynamique d'amplitude de la constellation et donc réduire la taille des zones de dépeuplement. Cette solution n'est que peu satisfaisante car l'augmentation de la taille du signal de commande entraine une augmentation de la quantité de données transmises au satellite, de la complexité de la phase de calibrage, de la taille des tables de calibrage, et de la taille des convertisseurs série-parallèle utilisés pour adresser les bits du signal de commande ;
- augmenter le pas du bit de poids faible des atténuateurs, de manière à augmenter la dynamique d'amplitude de la constellation à nombre de bits de commande constant et donc réduire la taille des zones de dépeuplement 330 et 340, comme on peut le voir dans les figures 3c et 3d, mais cette solution dégrade la densité des points de la constellation et donc la résolution du système ;
- utiliser une méthode hybride consistant à réaliser la synthèse de phase sur une dynamique faible à partir d'une approche vectorielle, à recombiner les signaux I et Q et à atténuer l'ensemble après recombinaison. Cette approche est cependant peu efficace en termes d'implémentation et de résolution versus le nombre total de bits requis du signal de commande.

Les demandes de brevet publiées US 5661489 A, FR 2338582 A1 et EP 3324540 A1 divulguent des atténuateurs et techniques de contrôle exemplaires.

Il existe donc un réel besoin pour un nœud de contrôle dans une antenne réseau permettant d'obtenir une constellation amplitude/phase homogène implémentable efficacement en technologie silicium ou silicium-germanium, et ce sans augmenter le nombre de bits du signal de commande, sans réduire la résolution du système, et sans impacter significativement la surface et la puissance requises.

Pour ceci, l'invention décrite porte sur un nœud de contrôle à commande numérique flexible de constellation vectorielle amplitude/phase qui répond à ce besoin puisqu'il permet une optimisation du compromis résolution/dynamique sans modifier le nombre de bits du signal de commande. Ce nœud de contrôle est basé sur un atténuateur dont les cellules d'atténuation du signal RF permettent un adressage différentié. Il s'implémente aisément sur tout type de technologie silicium CMOS (acronyme anglais pour « *Complementary metal oxide semi-conductor* », ou semi-conducteur complémentaire à l'oxyde de métal) grâce à sa capacité intrinsèque de synthèse de fonction logique combinatoire.

### Résumé de l'invention :

L'invention porte donc sur un atténuateur pour nœud de contrôle d'antenne réseau, configuré pour atténuer un signal radiofréquence en fonction d'un signal de commande, ledit atténuateur comprenant une pluralité de premières cellules d'atténuation, chaque première cellule d'atténuation étant configurée pour atténuer ledit signal radiofréquence d'une valeur prédéterminée et étant activée en fonction d'un bit particulier du signal de commande, l'atténuateur étant caractérisé en ce qu'il comprend un moyen de mise en œuvre d'une logique combinatoire à partir des bits du signal de commande utilisés pour commander les premières cellules d'atténuation, et au moins une deuxième cellule d'atténuation, chaque deuxième cellule d'atténuation étant configurée pour atténuer ledit signal radiofréquence d'une valeur prédéterminée et étant activée en fonction d'une sortie particulière du moyen de mise en œuvre d'une logique combinatoire.

Selon divers modes de réalisation, le moyen de mise en œuvre d'une logique combinatoire est une table préprogrammée, un dispositif de calculs numériques ou un circuit électronique intégré.

Avantageusement, les moyens de mise en œuvre d'une logique combinatoire sont configurés pour n'activer les deuxièmes cellules d'atténuation que lorsque les premières cellules d'atténuations sont dans leurs 2^{M}-1 états d'atténuation les plus forts.

Dans un mode de réalisation, l'atténuateur comprend en outre un ou plusieurs blocs de cellules d'atténuation additionnelles, chaque bloc comprenant au moins une cellule d'atténuation, chaque cellule d'atténuation d'un bloc étant configurée pour atténuer ledit signal radiofréquence d'une valeur prédéterminée et étant activée en fonction d'une sortie du moyen de mise en œuvre d'une logique combinatoire, dans lequel l'atténuation de la cellule de plus petite atténuation des deuxièmes cellules d'atténuation et l'atténuation de la cellule de plus petite atténuation de chacun desdits un ou plusieurs blocs de cellules d'atténuation additionnelles sont différentes.

L'invention porte également sur un nœud de contrôle pour antenne réseau, comprenant au moins un diviseur quadratique prenant en entrée un signal radiofréquence et délivrant au moins un signal en phase et un signal en quadrature de phase sur des voies de transmission distinctes et un combineur configuré pour générer un signal radiofréquence de sortie par sommation des signaux transmis sur deux des voies de transmission, le nœud de contrôle étant caractérisé en ce qu'il comprend pour chaque voie de transmission un atténuateur tel que décrit précédemment.

Selon un mode de réalisation du nœud de contrôle, le diviseur quadratique est configuré pour délivrer un signal en phase et un signal en quadrature de phase, et dans lequel chaque voie de transmission comprend en outre un inverseur configuré pour inverser le signal transmis sur la voie de transmission en fonction dudit signal de commande.

Selon un autre mode de réalisation du nœud de contrôle, le diviseur quadratique est configuré pour délivrer sur quatre voies de transmission différentes un signal en phase, un signal inverse du signal en phase, un signal en quadrature de phase et un signal inverse du signal en quadrature de phase, et dans lequel le combineur est configuré pour combiner les signaux transmis sur deux voies de transmission sélectionnées en fonction dudit signal de commande.

Enfin, l'invention porte sur une antenne réseau comprenant :
- une pluralité d'éléments rayonnants configurés pour émettre ou recevoir un signal radiofréquence, et
- un nœud de contrôle selon l'invention par élément rayonnant, le nœud de contrôle étant configuré pour mettre en forme le signal radiofréquence à émettre ou pour mettre en forme le signal radiofréquence reçu en fonction d'un signal de commande,
ainsi que sur un satellite comprenant une telle antenne réseau.

### Brève description des figures :

L'invention sera mieux comprise et d'autres caractéristiques et avantages apparaîtront mieux à la lecture de la description qui suit, donnée à titre non limitatif, et grâce aux figures annexées.
[Fig. 1] La figure 1 représente sommairement les principaux éléments d'une chaîne d'émission comprenant une antenne réseau.
[Fig. 2a] La figure 2a représente le synoptique des principaux éléments d'un nœud de contrôle unitaire à topologie polaire pour antenne réseau.
[Fig. 2b] La figure 2b représente la constellation d'états obtenue pour un nœud de contrôle utilisant une topologie polaire, dans le cas d'une constellation idéale.
[Fig. 3a] La figure 3a représente le synoptique des principaux éléments d'un nœud de contrôle unitaire à topologie vectorielle pour antenne réseau.
[Fig. 3b] La figure 3b représente la constellation d'états obtenue pour un nœud de contrôle utilisant une topologie vectorielle, dans le cas d'une constellation idéale.
[Fig. 3c] La figure 3c représente une autre constellation d'états obtenue pour un nœud de contrôle utilisant une topologie vectorielle.
[Fig. 3d] La figure 3d représente une autre constellation d'états obtenue pour un nœud de contrôle utilisant une topologie vectorielle.
[Fig. 4a] La figure 4a représente un nœud de contrôle selon un mode de réalisation de l'invention.
[Fig. 4b] La figure 4b représente la constellation d'états obtenue pour un nœud de contrôle unitaire selon un mode de réalisation de l'invention.
[Fig. 4c] La figure 4c représente la constellation d'états obtenue pour un nœud de contrôle unitaire selon un autre mode de réalisation de l'invention.
[Fig. 5a] La figure 5a représente un nœud de contrôle selon un mode de réalisation de l'invention.
[Fig. 5b] La figure 5b représente un nœud de contrôle selon un mode de réalisation de l'invention.
[Fig. 6a] La figure 6a représente la structure d'une cellule d'atténuation.
[Fig. 6b] La figure 6b représente la structure d'une cellule d'atténuation.

Par la suite, lorsque des mêmes références sont utilisées dans des figures, elles désignent les mêmes éléments.

### Description détaillée :

Le nœud de contrôle objet de l'invention a une structure vectorielle, et incorpore un atténuateur configuré pour permettre une plus grande dynamique que les atténuateurs de l'état de l'art sans pour autant modifier la taille du pas d'amplitude ou le nombre de bits du signal de commande.

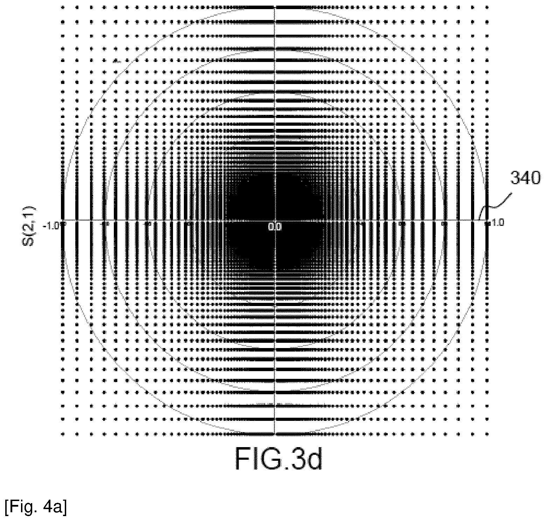

La figure 4a représente un nœud de contrôle unitaire selon un premier mode de réalisation de l'invention. Ce nœud de contrôle prend en entrée un signal RF à émettre sur un élément rayonnant particulier de l'antenne réseau. Il comprend un diviseur quadratique 301 configuré pour générer une voie *I* en phase et une voie *Q* en quadrature de phase à partir du signal RF. Chaque voie comprend un atténuateur 401/402 contrôlé par N - 1 bits particuliers du signal de commande, et un inverseur 304/305 contrôlé par un bit particulier du signal de commande. Les signaux sont ensuite recombinés par un combineur RF 306, qui somme les signaux transmis sur les deux voies en phase ou en opposition de phase.

L'atténuateur 401 comprend N - 1 cellules d'atténuation Aᵢ, avec *i∈*[1, *N* ― 1], configurées pour atténuer le signal radiofréquence d'une valeur prédéterminée en fonction de la valeur 310/311 de N - 1 bits particuliers du signal de commande. De manière à garantir un pas d'amplitude constant, l'atténuation double pour chaque cellule. Chaque cellule est contrôlée par un bit particulier du signal de commande, qui contrôle la génération d'un signal analogique de contrôle rendant active ou inactive la cellule d'atténuation, de manière à rendre cette dernière pilotable par une commande numérique.

L'atténuateur 401 selon un mode de réalisation de l'invention comprend un moyen 403 de mise en œuvre d'une logique combinatoire permettant de générer des signaux de commande additionnels à partir des bits du signal de commande utilisés pour commander les premières cellules d'atténuation. Dans le mode de réalisation décrit, le moyen de mise en œuvre d'une logique combinatoire prend la forme d'un circuit électronique de composants logiques prenant en entrée les signaux analogiques de contrôle de l'ensemble des cellules Aᵢ afin de générer un ou plusieurs signaux de consigne.

L'atténuateur 41 comprend également M cellules d'atténuation additionnelles Bⱼ, avec j compris entre 1 et M, configurées pour atténuer le signal radiofréquence d'une valeur prédéterminée en fonction d'un des signaux générés par le moyen de calcul 403. Ces cellules sont donc configurées pour être activées non pas en fonction de M bits supplémentaires du signal de commande, mais d'une combinaison optimisée de l'ensemble des N-1 bits du signal de commande utilisés pour les cellules Aᵢ. De cette manière, les cellules d'atténuation Bⱼ permettent d'étendre la dynamique d'amplitude de la constellation sans modifier la résolution initiale fixée par la valeur du bit de poids faible des cellules d'atténuation Aᵢ (et donc sans modifier le pas d'amplitude) ni augmenter le nombre de bits du signal de commande.

La logique combinatoire permet d'activer les cellules additionnelles Bⱼ sur des états particuliers du signal de commande. Avantageusement, elle est choisie pour activer les cellules additionnelles Bⱼ sur les 2^{M} - 1 derniers états de la table de vérité [A₁, .., A_{N-1}]. En effet, choisir ces états permet d'augmenter la dynamique sans créer de « trou de couverture » au milieu de la loi de commande d'atténuation. Ils correspondent d'ailleurs à des zones peu exploitées de la constellation, et leur déplacement impacte favorablement les performances du système par augmentation de la surface de couverture.

La valeur d'atténuation des cellules Bⱼ peut être choisie en fonction du nombre M de cellules et de la dynamique additionnelle d'amplitude souhaitée. De ce fait, la valeur d'atténuation choisie pour la cellule de poids faible des cellules additionnelles Bᵢ dépendra de la dynamique d'atténuation des cellules Aᵢ, du nombre M de cellules additionnelles et de la résolution recherchée dans la zone de dépeuplement. Tout comme pour les cellules Aᵢ, le niveau d'atténuation des cellules d'atténuation additionnelles Bⱼ double de cellule en cellule.

La table 1 décrit un exemple d'atténuations obtenues en choisissant N = 7, M = 2, A₁ = 0.3dB et B₁ = 2dB, et où les cellules Bⱼ sont activées sur les 3 derniers états de la table de vérité.

**[Table 1]**

| **Cmde** | **Att. A (dB)** | **Att. B (dB)** | **Att. totale (dB)** | **Cmde** | **Att. A (dB)** | **Att. B (dB)** | **Att. totale (dB)** |
|---|---|---|---|---|---|---|---|
| 000000 | 0,0 | 0 | 0 | 100000 | 9,6 | 0 | 9,6 |
| 000001 | 0,3 | 0 | 0,3 | 100001 | 9,9 | 0 | 9,9 |
| 000010 | 0,6 | 0 | 0,6 | 100010 | 10,2 | 0 | 10,2 |
| 000011 | 0,9 | 0 | 0,9 | 100011 | 10,5 | 0 | 10,5 |
| 000100 | 1,2 | 0 | 1,2 | 100100 | 10,8 | 0 | 10,8 |
| 000101 | 1,5 | 0 | 1,5 | 100101 | 11,1 | 0 | 11,1 |
| 000110 | 1,8 | 0 | 1,8 | 100110 | 11,4 | 0 | 11,4 |
| 000111 | 2,1 | 0 | 2,1 | 100111 | 11,7 | 0 | 11,7 |
| 001000 | 2,4 | 0 | 2,4 | 101000 | 12,0 | 0 | 12 |
| 001001 | 2,7 | 0 | 2,7 | 101001 | 12,3 | 0 | 12,3 |
| 001010 | 3,0 | 0 | 3 | 101010 | 12,6 | 0 | 12,6 |
| 001011 | 3,3 | 0 | 3,3 | 101011 | 12,9 | 0 | 12,9 |
| 001100 | 3,6 | 0 | 3,6 | 101100 | 13,2 | 0 | 13,2 |
| 001101 | 3,9 | 0 | 3,9 | 101101 | 13,5 | 0 | 13,5 |
| 001110 | 4,2 | 0 | 4,2 | 101110 | 13,8 | 0 | 13,8 |
| 001111 | 4,5 | 0 | 4,5 | 101111 | 14,1 | 0 | 14,1 |
| 010000 | 4,8 | 0 | 4,8 | 110000 | 14,4 | 0 | 14,4 |
| 010001 | 5,1 | 0 | 5,1 | 110001 | 14,7 | 0 | 14,7 |
| 010010 | 5,4 | 0 | 5,4 | 110010 | 15,0 | 0 | 15 |
| 010011 | 5,7 | 0 | 5,7 | 110011 | 15,3 | 0 | 15,3 |
| 010100 | 6,0 | 0 | 6 | 110100 | 15,6 | 0 | 15,6 |
| 010101 | 6,3 | 0 | 6,3 | 110101 | 15,9 | 0 | 15,9 |
| 010110 | 6,6 | 0 | 6,6 | 110110 | 16,2 | 0 | 16,2 |
| 010111 | 6,9 | 0 | 6,9 | 110111 | 16,5 | 0 | 16,5 |
| 011000 | 7,2 | 0 | 7,2 | 111000 | 16,8 | 0 | 16,8 |
| 011001 | 7,5 | 0 | 7,5 | 111001 | 17,1 | 0 | 17,1 |
| 011010 | 7,8 | 0 | 7,8 | 111010 | 17,4 | 0 | 17,4 |
| 011011 | 8,1 | 0 | 8,1 | 111011 | 17,7 | 0 | 17,7 |
| 011100 | 8,4 | 0 | 8,4 | 111100 | 18,0 | 0 | 18 |
| 011101 | 8,7 | 0 | 8,7 | 111101 | 18,3 | 2 | **20,3** |
| 011110 | 9,0 | 0 | 9 | 111110 | 18,6 | 4 | **22,6** |
| 011111 | 9,3 | 0 | 9,3 | 111111 | 18,9 | 6 | **24,9** |

Lorsque le signal de commande Cmde varie entre 000000 et 111100, les cellules Bⱼ sont inactives. L'atténuation totale de l'atténuateur correspond alors à l'atténuation fournie par les cellules Aᵢ, et vaut au maximum 18 dB. Lorsque le signal de commande vaut 111101, la cellule Bⱼ de poids faible est activée, et permet d'obtenir une atténuation supplémentaire du signal RF de 2dB, qui s'ajoute aux 18.3dB d'atténuation des cellules Aᵢ. De même, lorsque le signal de commande vaut 111110 et 111111, les cellules Bⱼ permettent d'obtenir un surcroît d'atténuation valant respectivement 4dB et 6dB. Les cellules additionnelles Bⱼ portent donc la dynamique totale de la constellation à 24.9dB au lieu de 18.9 dB, sans augmentation de la taille du signal de commande, et en ne modifiant la taille du pas de la constellation que sur les 3 derniers états, puisque les cellules d'atténuation supplémentaires n'introduisent pas de nouveaux états dans la constellation mais augmentent l'atténuation d'états existants et peu exploités de la constellation.

La logique combinatoire requise pour mettre en œuvre l'invention est très simple : en nommant Cmdeᵢ les bits du signal de commande, i variant entre 1 et 6 et Cmde₁ étant le bit de poids faible, la cellule additionnelle B₁ de poids faible (2dB d'atténuation) est activée si et seulement si les bits Cmde₁, Cmde₃, Cmde₄, Cmde₅ et Cmde₆ valent 1. La cellule B₂ (4dB d'atténuation) est activée si et seulement si les bits Cmde₂, Cmde₃, Cmde₄, Cmde₅ et Cmde₆ valent 1. Les moyens de mise en œuvre de la logique combinatoire peuvent donc être implémentés sous la forme d'un circuit intégré composé d'une série de portes logiques élémentaires « ET », rendant ainsi la solution physique très compacte.

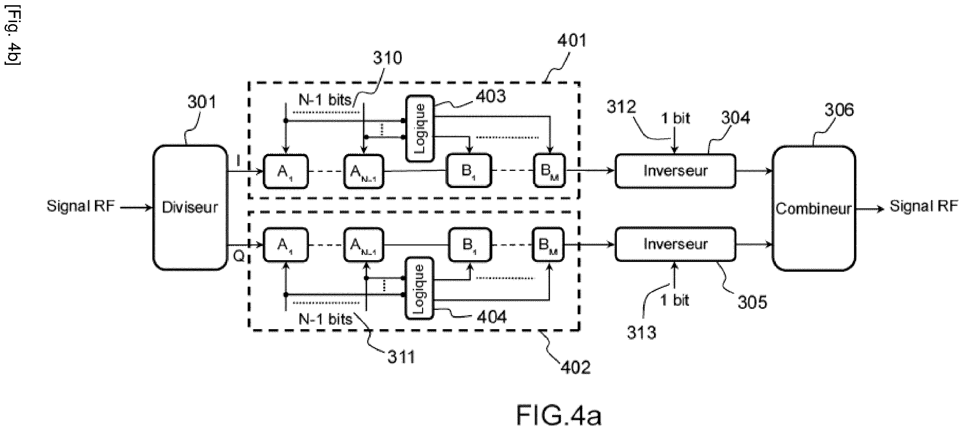

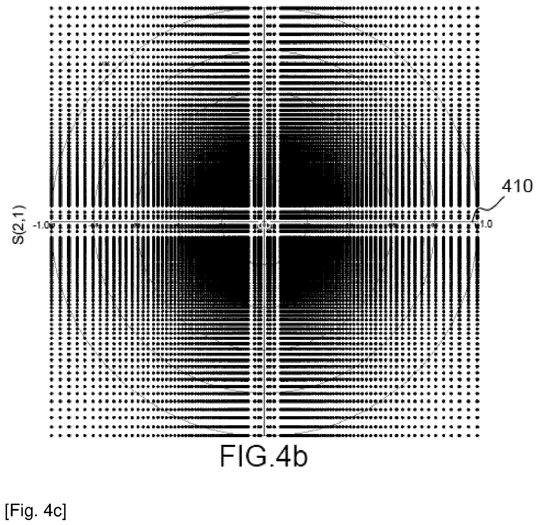

Les figures 4b et 4c illustrent la constellation obtenue par la mise en œuvre d'un atténuateur selon l'invention dans le cas d'une constellation vectorielle dans les conditions de la figure 3b avec M valant respectivement 2 et 3. On y observe que la zone dépeuplée 410 et 420 est réduite par rapport à la zone dépeuplée de la figure 3b, et que la densité de points de la zone dépeuplée augmente avec M.

La solution proposée répond donc bien au problème posé de combler les zones dépeuplées d'une constellation générée par un nœud de contrôle vectoriel sans augmenter la taille de la commande ou le pas de la constellation. Son impact sur la taille du composant nœud de contrôle est limité, l'ajout d'une cellule B supplémentaire se traduisant approximativement par une augmentation de l'ordre de 2 à 3% de la surface du circuit imprimé. Les pertes RF supplémentaires sont raisonnables d'un point de vue fonctionnement système.

La solution proposée permet une grande souplesse d'adaptation aux besoins opérationnels puisqu'elle est ajustable selon deux axes : le nombre de cellules Bⱼ peut être augmenté ou réduit, et la valeur de la cellule d'adaptation de poids faible B₁ peut être modifiée. De ce fait, la structure de l'atténuateur peut être ajustée pour une plus grande dynamique d'amplitude afin de combler les zones de dépeuplement. On parle de concept à double échelle puisque les cellules d'atténuation Aᵢ et Bⱼ atténuent chacune le signal RF selon une échelle particulière. Ce concept peut très simplement être étendu à un concept multi-échelles en ajoutant des blocs additionnels de cellules d'atténuations (par exemple Cₖ) pilotées sur des états précis du signal de commande pour encore augmenter la dynamique de l'atténuation ou mieux ajuster le pas de la constellation dans les zones de dépeuplement. Avantageusement, la valeur d'atténuation de la cellule de poids faible des cellules Cₖ sera alors différente de celle de la cellule de poids faible des cellules Bⱼ de manière à accroitre encore la flexibilité de conception et de performance du nœud de contrôle au regard de la loi d'atténuation.

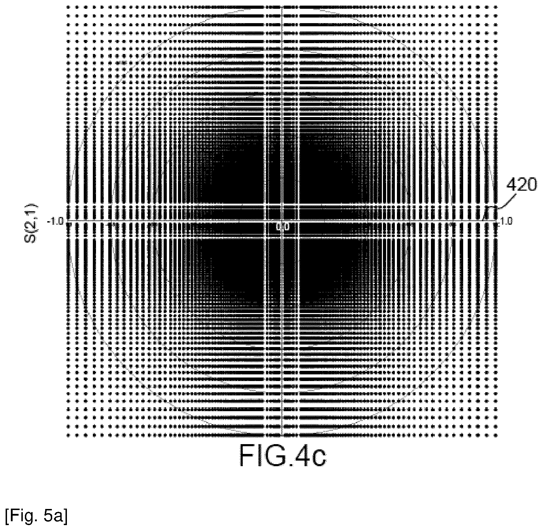

La figure 5a représente un autre mode de réalisation de l'invention, comparable en tous points à celui présenté en figure 4a sauf en ce qui concerne les moyens 510/511 de mise en œuvre d'une logique combinatoire. Dans ce mode de réalisation, la logique combinatoire est appliquée au signal numérique de commande, soit par le biais d'un composant de calculs numériques (comme par exemple un processeur numérique de signal, en anglais DSP pour « *Digital Signal Processor* » ou tout autre dispositif équivalent permettant de réaliser des calculs numériques), soit par le biais d'une table de correspondance pré-calculée faisant le lien entre les valeurs du signal de commande et l'activation des cellules d'atténuation Bⱼ.

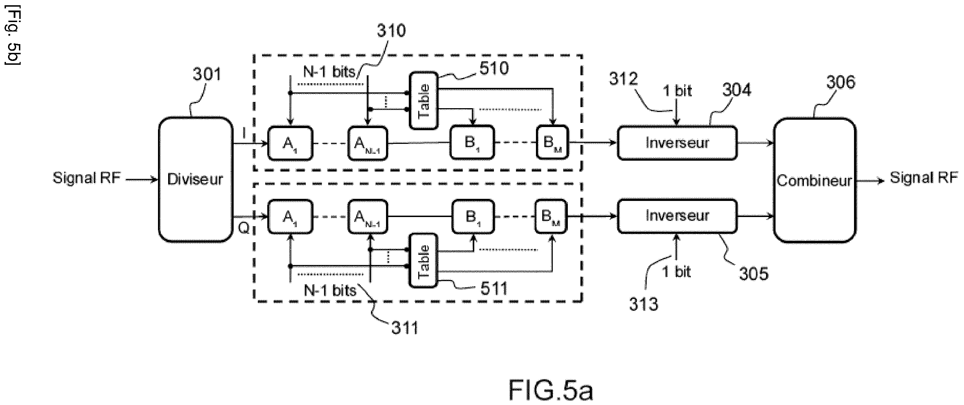

La figure 5b représente un autre mode de réalisation de l'invention, qui se différencie de celui représenté en figure 4a en ce que le diviseur quadratique 520 est configuré pour générer à partir du signal RF : une voie *I* en phase, une voie *I̅* inverse de la voie *I*, une voie Q en quadrature de phase, et une voie *Q̅* inverse de la voie Q . Un atténuateur tel que décrit précédemment, comprenant des premières cellules d'atténuation Aᵢ et des deuxièmes cellules d'atténuation Bⱼ, est disposé sur chacune des voies de transmission. Le signal de commande utilisé pour commander l'atténuateur d'une voie et de la voie inverse est le même. Le combineur 530 est configuré pour sélectionner une première voie parmi les voies *I* et *I̅*, et une deuxième voie parmi les voies Q et *Q̅,* et pour combiner ces deux voies afin de fournir le signal RF de sortie du nœud de contrôle. Les moyens de mise en œuvre de la logique combinatoire peuvent indifféremment être un circuit analogique intégré, comme pour la figure 4a, un dispositif de calcul numérique ou une table, comme pour la figure 5a.

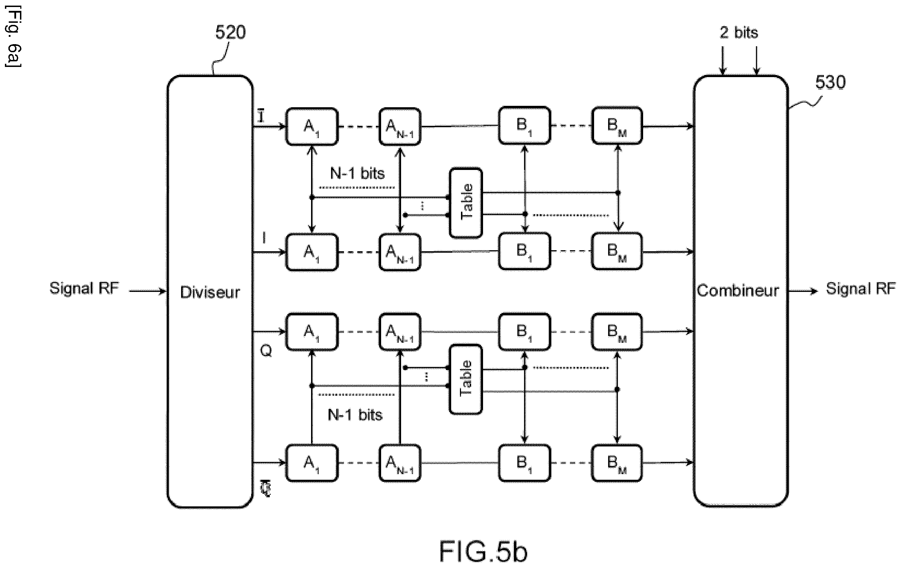

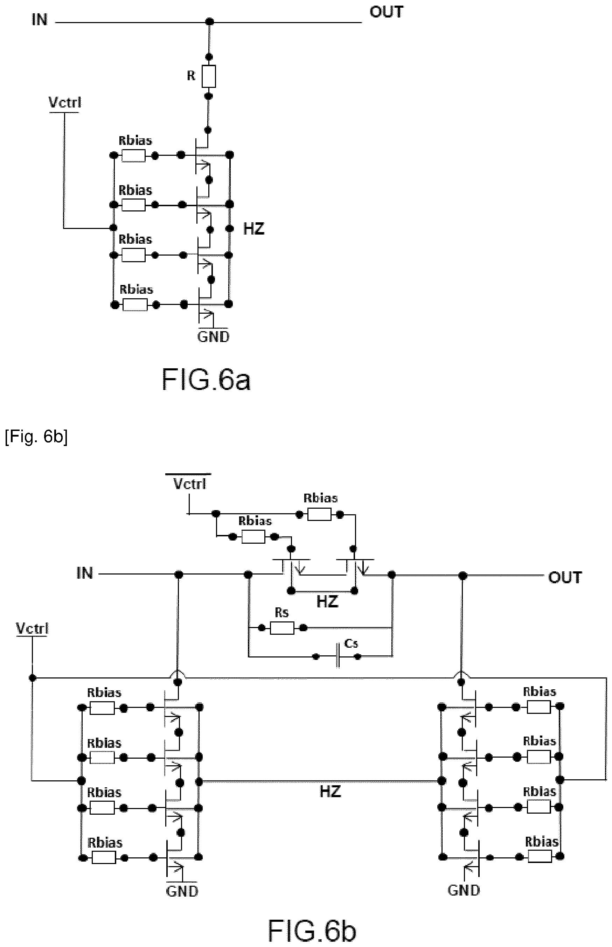

Les figures 6a et 6b représentent deux modes de réalisation d'une cellule d'atténuation en circuit intégré telles que connues de l'état de l'art, données à titre d'illustration. Une cellule d'atténuation prend en entrée un signal radiofréquence IN et délivre un signal radiofréquence OUT. En fonction de la valeur d'une tension de contrôle Vctrl, la cellule atténue le signal radiofréquence d'une valeur déterminée ou le laisse passer sans le modifier (OUT = IN). Pour ceci, chaque cellule forme un circuit électrique dont le choix des composants (Rs, Rbias, Cs), de leurs valeurs et de leurs agencements permet de déterminer l'atténuation réalisée. La tension de contrôle Vctrl est appliquée en tant que tension de grille des transistors, et permet de définir leur état passant ou non passant. De cette manière, l'activation de la tension de contrôle Vctrl en fonction d'un bit particulier du signal de commande permet de contrôler l'état actif/inactif de la cellule d'atténuation. Les figures 6a et 6b illustrent deux modes de réalisation d'une cellule d'atténuation, mais de nombreux autres agencements sont connus de l'homme du métier, qui pourraient être utilisés de la même manière pour mettre en œuvre l'invention décrite. La figure 6a réalise une atténuation plutôt faible du signal radio, et conviendrait donc particulièrement à la réalisation d'une cellule d'atténuation de poids faible, tandis que la figure 6b réalise une atténuation plus élevée, et conviendrait particulièrement à la réalisation d'une cellule d'atténuation de poids fort.

La cellule d'atténuation à double-échelle, une première échelle liée aux atténuateurs Aᵢ et une deuxième échelle liée aux atténuateurs Bⱼ, décrite est donc une solution optimisée de synthèse vectorielle de constellations amplitude/phase appliquée aux réseaux de formateurs de faisceaux d'antennes réseau. Le dispositif, basé sur l'intégration de cellules d'atténuation additionnelles Bⱼ pilotables selon une logique combinatoire des bits de commandes des cellules Aᵢ constituant le schéma de référence, permet une flexibilité de design décuplée pour la réalisation du meilleur compromis entre dynamique et résolution du système, sans impact sur le nombre de bits de commande associés.

L'invention porte également sur une antenne réseau comprenant un réseau de formateurs de faisceaux intégrant des nœuds de contrôle unitaires tels que décrits précédemment, et un satellite embarquant une telle antenne.

## Revendications

1. Atténuateur (401) pour nœud de contrôle d'antenne réseau (103), configuré pour atténuer un signal radiofréquence en fonction d'un signal de commande, ledit atténuateur comprenant une pluralité de premières cellules d'atténuation (A₁, A_{N-1}), chaque première cellule d'atténuation étant configurée pour atténuer ledit signal radiofréquence d'une valeur prédéterminée et étant activée en fonction d'un bit particulier du signal de commande (310), l'atténuateur étant **caractérisé en ce qu'**il comprend un moyen (403, 404, 510, 511) de mise en œuvre d'une logique combinatoire sur les bits du signal de commande utilisés pour commander les premières cellules d'atténuation, et au moins une deuxième cellule d'atténuation (B₁, B_{M}), chaque deuxième cellule d'atténuation étant configurée pour atténuer ledit signal radiofréquence d'une valeur prédéterminée et étant activée en fonction d'une sortie particulière du moyen de mise en œuvre de la logique combinatoire.

2. Atténuateur selon l'une des revendications précédentes, dans lequel le moyen de mise en œuvre d'une logique combinatoire est une table préprogrammée (510, 511).

3. Atténuateur selon l'une des revendications précédentes, dans lequel le moyen de mise en œuvre d'une logique combinatoire est un dispositif de calculs numériques (510, 511).

4. Atténuateur selon l'une des revendications précédentes, dans lequel le moyen de mise en œuvre d'une logique combinatoire est un circuit électronique intégré (403, 404).

5. Atténuateur selon l'une des revendications précédentes comprenant M deuxièmes cellules d'atténuation, dans lequel les moyens de mise en œuvre d'une logique combinatoire sont configurés pour n'activer les deuxièmes cellules d'atténuation que lorsque les premières cellules d'atténuations sont dans leurs 2^{M}-1 états d'atténuation les plus forts.

6. Atténuateur selon l'une des revendications précédentes, comprenant en outre un ou plusieurs blocs de cellules d'atténuation additionnelles, chaque bloc comprenant au moins une cellule d'atténuation, chaque cellule d'atténuation d'un bloc étant configurée pour atténuer ledit signal radiofréquence d'une valeur prédéterminée et étant activée en fonction d'une sortie du moyen de mise en œuvre d'une logique combinatoire, dans lequel l'atténuation de la cellule de plus petite atténuation des deuxièmes cellules d'atténuation et l'atténuation de la cellule de plus petite atténuation de chacun desdits un ou plusieurs blocs de cellules d'atténuation additionnelles sont différentes.

7. Nœud de contrôle pour antenne réseau, comprenant au moins un diviseur quadratique (301, 520) prenant en entrée un signal radiofréquence et délivrant au moins un signal en phase et un signal en quadrature de phase sur des voies de transmission distinctes et un combineur (306, 530) configuré pour générer un signal radiofréquence de sortie par sommation des signaux transmis sur deux des voies de transmission, le nœud de contrôle étant **caractérisé en ce qu'**il comprend pour chaque voie de transmission un atténuateur selon l'une des revendications 1 à 6.

8. Nœud de contrôle selon la revendication 7 dans lequel le diviseur quadratique (301) est configuré pour délivrer un signal en phase et un signal en quadrature de phase, et dans lequel chaque voie de transmission comprend en outre un inverseur (304, 305) configuré pour inverser le signal transmis sur la voie de transmission en fonction dudit signal de commande.

9. Nœud de contrôle selon la revendication 7 dans lequel le diviseur quadratique (520) est configuré pour délivrer sur quatre voies de transmission différentes un signal en phase, un signal inverse du signal en phase, un signal en quadrature de phase et un signal inverse du signal en quadrature de phase, et dans lequel le combineur (530) est configuré pour combiner les signaux transmis sur deux voies de transmission sélectionnées en fonction dudit signal de commande.

10. Antenne réseau comprenant :
- une pluralité d'éléments rayonnants (106) configurés pour émettre ou recevoir un signal radiofréquence,
- un nœud de contrôle selon l'une des revendications 7 à 9 par élément rayonnant (104), le nœud de contrôle étant configuré pour mettre en forme le signal radiofréquence à émettre ou pour mettre en forme le signal radiofréquence reçu en fonction d'un signal de commande.

11. Satellite comprenant une antenne réseau selon la revendication 10.

## Patentansprüche

1. Dämpfer (401) für einen Kontrollknoten einer Netzwerkantenne (103), welcher zum Dämpfen eines Funkfrequenz-Steuersignals konfiguriert ist, wobei der Dämpfer eine Vielzahl von ersten Dämpfungszellen (A₁, A_{N-1}) umfasst, wobei jede erste Dämpfungszelle konfiguriert ist, um das Funkfrequenzsignal um einen vorbestimmten Wert zu dämpfen und angesichts eines besonderen Bits des Steuersignals (310) aktiviert wird, wobei der Dämpfer **dadurch gekennzeichnet ist, dass** er ein Mittel (403, 404, 510, 511) zur Implementierung einer kombinatorischen Logik an den Bits des Steuersignals umfasst, welche verwendet werden, um die ersten Dämpfungszellen zu steuern, und mindestens eine zweite Dämpfungszelle (B₁, B_{M}), wobei jede zweite Dämpfungszelle konfiguriert ist, um das Funkfrequenzsignal um einen vorbestimmten Wert zu dämpfen und angesichts eines besonderen Ausgangs des Mittels zur Implementierung der kombinatorischen Logik aktiviert wird.

2. Dämpfer nach einem der vorhergehenden Ansprüche, wobei das Mittel zur Implementierung einer kombinatorischen Logik eine vorprogrammierte Tabelle (510, 511) ist.

3. Dämpfer nach einem der vorhergehenden Ansprüche, wobei das Mittel zur Implementierung einer kombinatorischen Logik eine digitale Rechenvorrichtung (510, 511) ist.

4. Dämpfer nach einem der vorhergehenden Ansprüche, wobei das Mittel zur Implementierung einer kombinatorischen Logik eine integrierte elektronische Schaltung (403, 404) ist.

5. Dämpfer nach einem der vorhergehenden Ansprüche, umfassend M zweite Dämpfungszellen, wobei die Mittel zur Implementierung einer kombinatorischen Logik konfiguriert sind, um die zweiten Dämpfungszellen nur zu aktivieren, wenn die ersten Dämpfungszellen in ihren 2^{M}-1 stärksten Dämpfungszuständen sind.

6. Dämpfer nach einem der vorhergehenden Ansprüche, ferner umfassend einen oder mehrere Blöcke von zusätzlichen Dämpfungszellen, wobei jeder Block mindestens eine Dämpfungszelle umfasst, wobei jede Dämpfungszelle eines Blocks konfiguriert ist, um das Funkfrequenzsignal um einen vorbestimmten Wert zu dämpfen und gemäß einem Ausgang des Mittels zur Implementierung einer kombinatorischen Logik aktiviert wird, wobei die Dämpfung der Zelle mit der kleinsten Dämpfung der zweiten Dämpfungszellen und die Dämpfung der Zelle mit der kleinsten Dämpfung eines jeden des einen oder der mehreren Blöcke von zusätzlichen Dämpfungszellen unterschiedlich sind.

7. Kontrollknoten für Netzwerkantenne, umfassend mindestens einen quadratischen Teiler (301, 520), welcher als Eingang ein Funkfrequenzsignal nimmt und mindestens ein Phasen- und ein Phasenquadratursignal über unterschiedliche Übertragungskanäle abgibt, und einen Kombinator (306, 530), welcher konfiguriert ist, um ein Funkfrequenz-Ausgangssignale durch Summierung der über zwei der Übertragungskanäle übertragenen Signale zu erzeugen, wobei der Kontrollknoten **dadurch gekennzeichnet ist, dass** er für jeden Übertragungskanal einen Dämpfer nach einem der Ansprüche 1 bis 6 umfasst.

8. Kontrollknoten nach Anspruch 7, wobei der quadratische Teiler (301) konfiguriert ist, um ein Phasen- und ein Phasenquadratursignal abzugeben, und wobei jeder Übertragungskanal ferner einen Inverter (304, 305) umfasst, welcher konfiguriert ist, um das über den Übertragungskanal übertragene Signal gemäß dem Steuersignal zu invertieren.

9. Kontrollknoten nach Anspruch 7, wobei der quadratische Teiler (520) konfiguriert ist, um über vier unterschiedliche Übertragungskanäle ein Phasensignal, ein invertiertes Signal des Phasensignals, ein Phasenquadratursignal und ein invertiertes Signal des Phasenquadratursignals abzugeben, und wobei der Kombinator (530) konfiguriert ist, um die über zwei Übertragungskanäle, welche gemäß dem Steuersignal ausgewählt sind, übertragenen Signale zu kombinieren.

10. Netzwerkantenne, Folgendes umfassend:
- eine Vielzahl von Strahlelementen (106), welche konfiguriert ist, um ein Funkfrequenzsignal zu senden oder zu empfangen,
- einen Kontrollknoten nach einem der Ansprüche 7 bis 9 pro Strahlelement (104), wobei der Kontrollknoten konfiguriert ist, um das zu sendende Funkfrequenzsignal oder das empfangene Funkfrequenzsignal gemäß dem Steuersignal in Form zu bringen.

11. Satellit, umfassend eine Netzwerkantenne nach Anspruch 10.

## Claims

1. Attenuator (401) for an array antenna control node (103), configured to attenuate a radiofrequency signal according to a control signal, said attenuator comprising a plurality of first attenuation cells (A₁, A_{N-1}), each first attenuation cell being configured to attenuate said radiofrequency signal by a predetermined value and being activated according to a particular bit of the control signal (310), the attenuator being **characterized in that** it comprises a means (403, 404, 510, 511) for implementing a combinatorial logic on the bits of the control signal that are used to control the first attenuation cells, and at least one second attenuation cell (B₁, B_{M}), each second attenuation cell being configured to attenuate said radiofrequency signal by a predetermined value and being activated according to a particular output of the means for implementing the combinatorial logic.

2. Attenuator according to one of the preceding claims, wherein the means for implementing a combinatorial logic is a preprogrammed table (510, 511).

3. Attenuator according to one of the preceding claims, wherein the means for implementing a combinatorial logic is a digital computing device (510, 511).

4. Attenuator according to one of the preceding claims, wherein the means for implementing a combinatorial logic is an integrated electronic circuit (403, 404).

5. Attenuator according to one of the preceding claims, comprising M second attenuation cells, wherein the means for implementing a combinatorial logic are configured to activate the second attenuation cells only when the first attenuation cells are in their 2^{M}-1 highest attenuation states.

6. Attenuator according to one of the preceding claims, further comprising one or more blocks of additional attenuation cells, each block comprising at least one attenuation cell, each attenuation cell of a block being configured to attenuate said radiofrequency signal by a predetermined value and being activated according to an output of the means for implementing a combinatorial logic, wherein the attenuation of the cell of lowest attenuation of the second attenuation cells and the attenuation of the cell of lowest attenuation of each of said one or more blocks of additional attenuation cells are different.

7. Control node for an array antenna, comprising at least one quadratic divider (301, 520) taking as input a radiofrequency signal and delivering at least one in-phase signal and one phase quadrature signal over distinct transmission channels and a combiner (306, 530) configured to generate an output radiofrequency signal by summing the signals transmitted over two of the transmission channels, the control node being **characterized in that** it comprises, for each transmission channel, an attenuator according to one of claims 1 to 6.

8. Control node according to claim 7, wherein the quadratic divider (301) is configured to deliver an in-phase signal and a phase quadrature signal, and wherein each transmission channel further comprises an inverter (304, 305) configured to invert the signal transmitted over the transmission channel according to said control signal.

9. Control node according to claim 7, wherein the quadratic divider (520) is configured to deliver, over four different transmission channels, an in-phase signal, an inverse signal of the in-phase signal, a phase quadrature signal and an inverse signal of the phase quadrature signal, and wherein the combiner (530) is configured to combine the signals transmitted over two selected transmission channels according to said control signal.

10. Array antenna comprising:
- a plurality of radiating elements (106) configured to transmit or receive a radiofrequency signal;
- one control node according to one of claims 7 to 9 per radiating element (104), the control node being configured to shape the radiofrequency signal to be transmitted or to shape the radiofrequency signal received according to a control signal.

11. Satellite comprising an array antenna according to claim 10.
